# EUROPEAN PATENT SPECIFICATION

(11) **EP 3 185 291 B1**
(45) Date of publication and mention of the grant of the patent: **23.09.2020**
(21) Application number: 15201716.6
(22) Date of filing: 21.12.2015
(51) Int. Cl.: H01L 23/495

(54) **A LEADFRAME AND A METHOD OF MANUFACTURING A LEADFRAME**
LEITRAHMEN UND VERFAHREN ZUR HERSTELLUNG EINES LEITERRAHMENS
GRILLE DE CONNEXION ET PROCÉDÉ DE FABRICATION D'UNE GRILLE DE CONNEXION

(43) Date of publication of application: 28.06.2017
(73) Proprietor: Nexperia B.V., 6534 AB Nijmegen (NL)
(72) Inventor: Ng, To Kam, Redhill, Surrey RH1 1SH (GB); Chau, On Lok, Redhill, Surrey RH1 1SH (GB); Ho, Wai Keung, Redhill, Surrey RH1 1SH (GB)

(56) References cited:
- EP-A1- 0 450 223
- JP-A- H0 758 274
- JP-A- S60 254 759
- JP-A- S61 139 050

## Description

The present disclosure relates to leadframes for integrated circuits, and methods of manufacturing leadframes.

JP H0758274 relates to a lead frame in which a drop in the electric resistance of an inner lead is made compatible with the enhancement of the mechanical strength of an outer lead.

JP S60254759 relates to a semiconductor-chip mounting part by arranging plate members, which comprise a high electric conductivity metallic material and has the same width, on both sides of a plate member comprising a metallic material having a low thermal expansion coefficient.

EP 0450223 relates to semiconductor chips are mounted on and resin-sealed in island portions of lead frames fabricated from a strip of substrate material.

JPS61139050 relates to forming a Cu oxide film on the surface of the lead frame.

According to a first aspect of the present disclosure there is provided a method of manufacturing a leadframe, according to claims 1 to 9.

Such a method can be economical and efficient.

There is also provided a leadframe according to claims 10 to 11.

There is also provided an integrated circuit comprising any leadframe disclosed herein.

While the disclosure is amenable to various modifications and alternative forms, specifics thereof have been shown by way of example in the drawings and will be described in detail. One or more embodiments will now be described by way of example only with reference to the accompanying drawings in which:
Figure 1 shows schematically a process flow for manufacturing a leadframe;
Figure 2 shows schematically an example embodiment of a process flow for manufacturing a leadframe;
Figure 3 shows graphically the steps involved in an example embodiment of manufacturing a leadframe;
Figure 4 shows an example embodiment of an integrated circuit that includes a leadframe that has been manufactured according to figure 3;
Figure 5a shows a side view of the IC of figure 4;
Figure 5b shows a close up view of the end of one of the leads of the IC of figures 4 and 5a;
Figure 6a shows a side view of an IC that has been manufactured according to the method of figure 1;
Figure 6b shows a close up view of the end of one of the leads of the IC of figure 6a; and
Figures 7, 8, 9 and 10 illustrate cross-sectional end views of four different ICs.

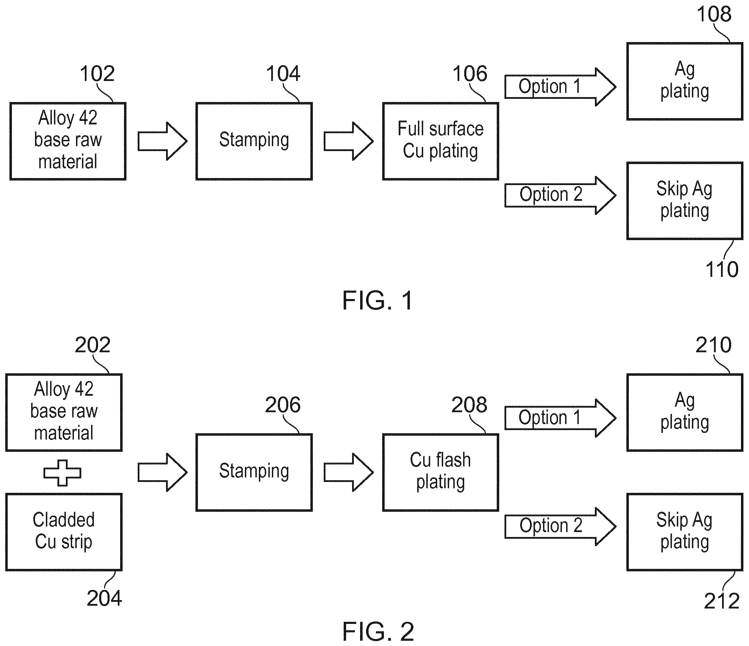

Figures 1, 6a, 6b, 7 and 8 are illustrative only.

As is known in the art, leadframes are metal structures that are inside an integrated circuit package (chip) and carry signals from the die to a package lead, for connecting to the outside world. Bond wires can be used to electrically connect the die to the leadframe.

High temperature eutectic die bonding is used in some applications for bonding the silicon die to the leadframe. In such examples, the leadframe can include an Alloy 42 base material. Alloy 42 is a known material that comprises 42% nickel content and 58% iron content, and has a low coefficient of thermal expansion (CTE). In this way, the CTE of the leadframe can advantageously be matched with that of the die material. Therefore, when high temperatures are applied for the eutectic die bonding process, the die and the leadframe expand at similar rates and therefore reduce the likelihood of any mechanical difficulties when the materials subsequently cool down or heat up. For example, mechanical stress between the die and the leadframe as they contract.

When Alloy 42 is used in this way, a copper layer can be located between the die and the Alloy 42. The copper layer should be thick enough to provide good thermal and electrical conductivity performance. The copper layer can be fabricated by a plating process, as discussed below with reference to figure 1.

Figure 1 shows schematically a process flow for manufacturing a leadframe. At step 102, an Alloy 42 base raw material is received, which may be provided as a sheet from a roll.

As indicated above, use of Alloy 42 can provide good CTE matching with the die. At step 104, the Alloy 42 material is stamped into the desired shape of the leadframe.

At step 106, the stamped Alloy 42 material is plated with copper over its entire outer surface. The copper plate may be about 6µm thick in order to provide good thermal and electrical conductivity performance. However, performing a plating operation for such a thick layer of copper may be disadvantageous in some examples. For example, it may be uneconomical or inefficient.

Step 108 in figure 1 illustrates that an optional silver plating operation can be performed on the leadframe. Such silver plating can enhance the quality of bonding for subsequent connections to the die. Alternatively, as shown by step 110, a silver plating operation may not be used. In such examples, a copper wire can be bonded directly onto a copper surface of the leadframe.

One or more example embodiments disclosed herein can use a metal cladding technique to create a thick copper layer only at required locations in the raw material, instead of a plating process such as the one illustrated in figure 1.

Figure 2 shows schematically an example embodiment of a process flow for manufacturing a leadframe.

At step 202, the method receives an Alloy 42 base raw material, which again may be provided as a sheet from a roll. In this example, the Alloy 42 base material includes an indentation, which can be provided as a groove running continuously along the sheet. At step 204, a copper inlay is inserted into indentation in the Alloy 42 material. This provides a leadframe-material that comprises both a base layer that comprises a first material (Alloy 42 in this example) and an inlay that comprises a second material (copper in this example). The copper inlay may have a thickness of about 4µm to 20µm, or about 4µm to 10µm, or about 5µm to 7µm. It will be appreciated that the specific thickness of the copper inlay may depend upon a specific application, and that the copper inlay should be thick enough to provide the leadframe with desired electrical and thermal properties.

It will be appreciated that a material that comprises copper includes copper alloys, and derivatives of copper. Therefore any reference to copper in this document should be construed as covering copper alloys and copper derivatives.

Advantageously, the indentation in the Alloy 42 base raw material can be provided only at locations in the eventual leadframe that require the improved electrical and thermal conductivity that is provided by the copper. Such locations can include the position of bond pads in the final leadframe, such as pads for die bonding and wire bonding. Therefore, regions of the leadframe that do not require improved electrical and thermal productivity do not necessarily include a region of copper inlay. The insertion of the inlay may be referred to as a metal cladding operation.

At step 206, a leadframe is formed from the leadframe-material. In this example, the leadframe is formed by stamping the leadframe-material into the desired shape of the leadframe. Such stamping can remove material that is not required for the leadframe. In this way, a leadframe can be provided that has an appropriate amount / thickness of copper in regions that require electrical and thermal conductivity, whilst retaining a sufficient amount of Alloy 42 such that the leadframe as a whole has the necessary CTE properties. In other examples, the leadframe is formed out of the leadframe-material by an etching operation.

Advantageously, use of such an inlay provides for using copper alloys with different properties for the inlay, for different thermal and electrical conductivity applications. The leadframe can also be applied to approaches in which copper wires applied to bare copper bond pads. The leadframe may also not require additional silver plating. Furthermore, eliminating a thick copper plating process can widen the leadframe supply. Further still, use of an inlay can provide an efficient and economical method of manufacturing a leadframe with desired electrical, thermal and CTE properties.

The method of figure 2 can apply a metal cladding technique to create a thick copper layer at the required location in the raw material. Upfront design of the raw material may be involved to provide the necessary indentations. The metal cladded raw material can then be used in subsequent leadframe manufacture.

In figure 2, at step 208 the method involves the step of performing a copper flash plating operation. Such a plating operation involves plating the leadframe with a relatively thin copper layer, for example one that is about 1µm thick. In other examples, the relatively thin copper layer has a thickness of less than about than 2µm or 1µm. The thin copper layer can provide a smooth and consistent finish to the leadframe. Plating a thin copper layer in optional step 208 of figure 2 may not suffer from the same inefficiencies as occur when plating a thick copper layer, as discussed above with reference to figure 1.

In the same way as figure 1, the method of figure 2 can include a silver plating operation 210, or the silver plating operation can be skipped (step 212).

A leadframe manufactured according to the method of figure 2 can be used in plastic surface-mounted packages, such as SOT23 from NXP™.

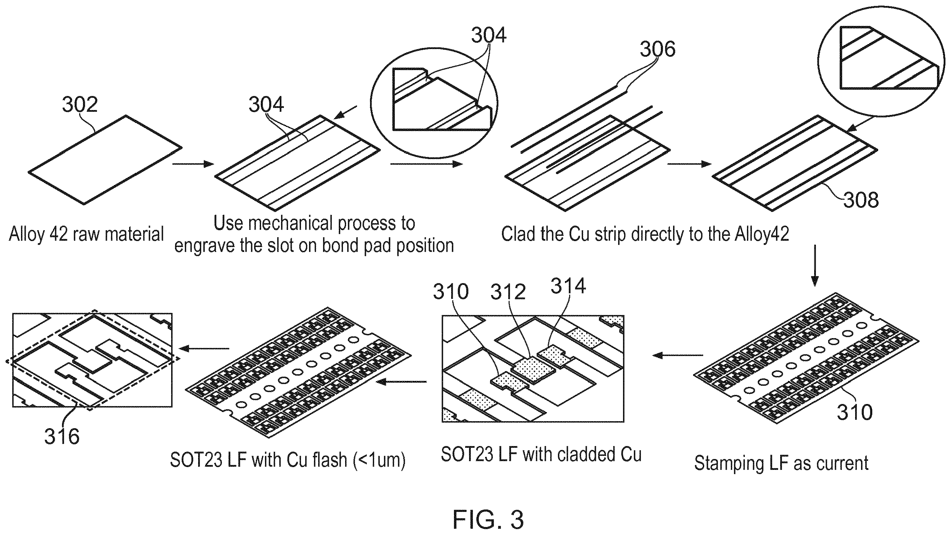

Figure 3 shows graphically the steps involved in an example embodiment of manufacturing a leadframe.

Figure 3 shows a base layer 302 of Alloy 42 raw material. A mechanical process is used in this example to engrave slots / grooves 304 at locations that will correspond to bond pad positions in the final leadframe. The grooves 304 in this example are straight, which can be convenient for manufacture. Then copper strips / inlays 306 are inserted into the grooves 304 and are clad directly to the Alloy 42 material. The cladding operation may involve applying pressure to the interface between the base layer 302 and the inlays 306 such that the two different materials then are provided together as a single sheet of leadframe-material 308.

To create a narrow groove 304, a carving tool can be installed in a rolling passage of the base layer 302 such that the groove 304 is carved out as the base layer 302 is rolled reel-to-reel. To create a wider groove, a rolling tool can be used to form and shape the groove. Subsequently, the inlays 306 can be applied in-line in the rolling passage, to complete the cladded insert in the reel-to-reel leadframe. The cladding process can be considerably less expensive than the plating process of figure 1, and can make more efficient use of materials.

In other examples, the base layer may be provided pre-processed with the indentations / groves 304 and therefore an engraving operation may not be required.

The leadframe-material 308 is then stamped or etched in order to provide a sheet of material that includes a plurality of individual leadframes. In this example, each leadframe includes three bond pad regions 310, 312, 314 because the corresponding chip will have three leads. It can be seen from figure 3 that each bond pad region 310, 312, 314 corresponds to a location in the leadframe that includes a copper inlay.

The leadframe is subsequently plated with a layer of copper that is relatively thin. For example, less than 2µm, 1µm or 0.5µm. A close up view of a single copper plated leadframe 316 (for a single IC) is shown in figure 3.

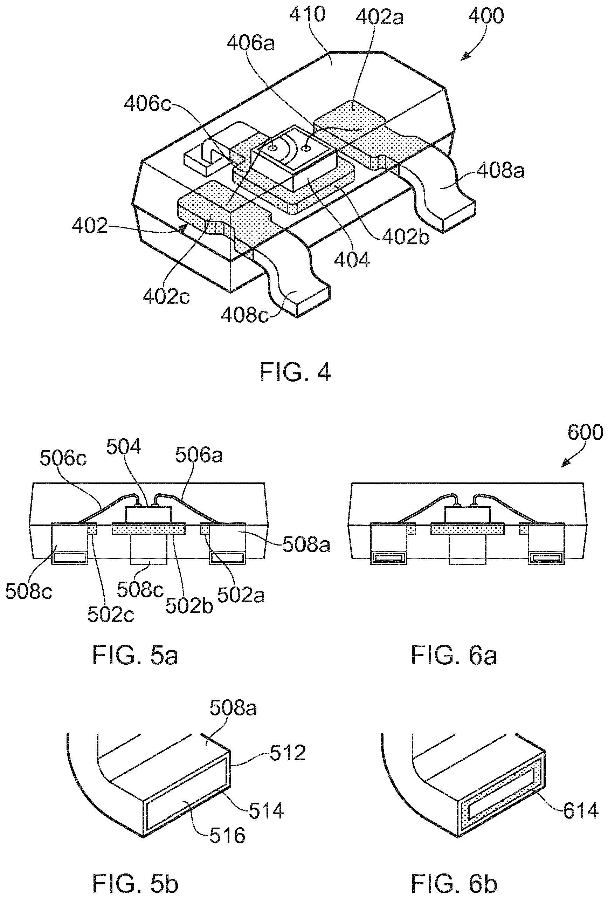

Figure 4 shows an example embodiment of an integrated circuit (IC) 400 that includes a leadframe 402 that has been manufactured according to figure 3. The IC 400 has three leads / pins, although only a first lead 408a and a second lead 408b can be seen in figure 4. The leadframe 400 includes three components 402a, 402b, 402c, one for each lead, which are shown as separate from each other in figure 4 because the outside of the leadframe shown in figure 3 has been removed.

A die 404 is shown as attached to a second component 402b of the leadframe. The die 404 is attached to a first component 402a of the leadframe by a first bond wire 406a. The die 404 is attached to a third component 402c of the leadframe by a third bond wire 406c. The die 404 and the bond wires 406a, 406c are attached to each the components 402a, 402b, 402c of the leadframe at bond pad regions of the leadframe. As discussed above with reference to figure 3, each of these bond pad regions corresponds to a location of the leadframe that has the copper inlay (not visible in figure 4).

In this example, the leads of the IC 400, that are outside a plastic casing 410 of the device, are regions of the leadframe 402 that have been plated with tin.

Figure 5a shows a side view of the IC 400 of figure 4. Feature of figure 5a that have already been described with reference to figure 4 have been given corresponding reference numbers in the 500 series, and will not necessarily be described again here. In figure 5a, the second lead / pin 508c is also visible.

Figure 5b shows a close up view of the end of one of the leads of the IC of figures 4 and 5a. The view of figure 5b shows the three separate materials that make up this part of the leadframe. An outer layer of tin plating 512 is shown. Immediately inside the layer of tin plating 512 is a thin layer of copper plating 514. As discussed with reference to figure 3, this layer of copper plating 514 may have a thickness of about 1µm, and is not included to significantly improve the electrical and thermal conductivity of the leadframe in the bond pad regions. Inside the thin layer of copper plating 514 is the Alloy 42 base layer 516.

Figure 6a shows a side view of an IC 600 that has been manufactured according to the method of figure 1; that is, one in which a thick layer of copper plating has been used to provide the requisite electrical and thermal conductivity. The features of figure 6a will not be described in detail because, externally at least, figure 6a is very similar to figure 5a.

Figure 6b shows a close up view of the end of one of the leads of the IC 600 of figure 6a. The view of figure 6b shows the materials that make up this part of the leadframe, which are the same materials as shown in figure 5b. However, in contrast to figure 5b, in figure 6b, the layer of copper plating 614 is much thicker. This is because this layer of copper plating 614 is also included in the bond pad regions to provide the requisite electrical and thermal conductivity of the leadframe.

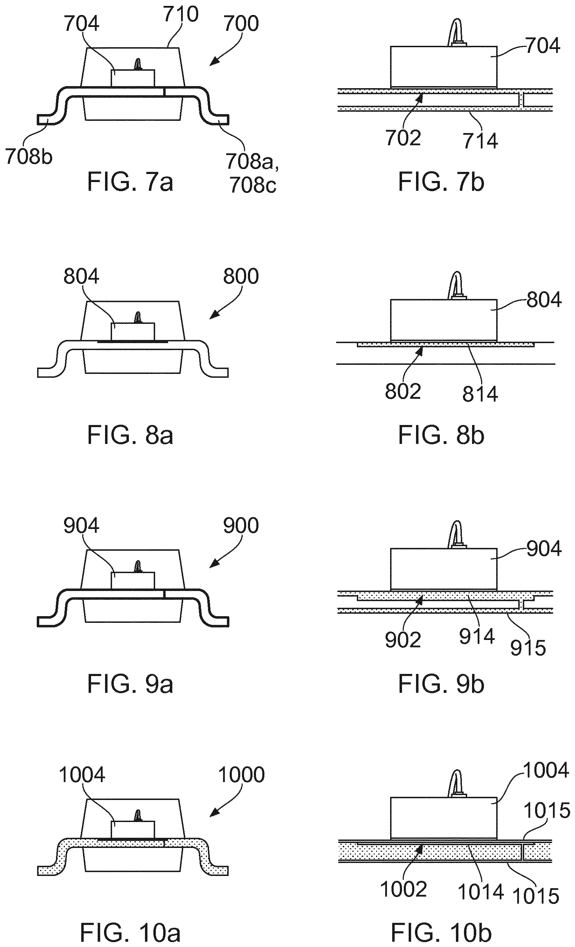

Figures 7, 8, 9 and 10 illustrate cross-sectional end views of four different ICs. In these views, various dimensions of layers of material have been exaggerated for ease of illustration.

Figure 7a shows a cross-sectional end view of an IC 700, and shows a die 704, a first and third lead 708a, 708c that are one behind the other, and a second lead 708b. The leads 708a, 708b, 708c, which are external to the plastic casing 740 of the IC 700, are plated with tin.

Figure 7b shows a close up view of the die 704 and a bond pad region 702 of the leadframe. The leadframe of the IC of figures 7a and 7b has been manufactured using a full copper plating operation on the entire leadframe, with a copper thickness of about 6µm. Therefore, the thickness of the copper plating 714 is consistent around the entire leadframe (both at the bond pad region 702, and at regions outside the bond pad region 702).

Figure 8a shows a cross-sectional end view of another IC 800, and shows a die 804. Figure 8b shows a close up view of the die 804 and a bond pad region 802 of the leadframe. In this example, the leadframe of the IC has been manufactured using a copper inlay / insert at only the bond pad regions, and copper plating operation has been used. Therefore, the only copper material 814 that is present in the leadframe at the bond pad region 802, which in this example is on a top side of a pad / lead area.

Figure 9a shows a cross-sectional end view of another IC 900, and shows a die 904. Figure 9b shows a close up view of the die 904 and a bond pad region 902 of the leadframe. In this example, the leadframe of the IC has been manufactured using a copper inlay at the bond pad regions, and also a flash copper plating operation. Therefore, the IC includes an inlay-portion 914 of copper material that is present in the leadframe at the bond pad region 802, as provided by the inlay. The IC also includes an outer-portion 915 of copper material over the entire leadframe, with a copper thickness of about 1µm, as provided by the flash copper plating operation. It will be appreciated that in other examples, outer-portion 915 of copper material need not necessarily be provided over the entire leadframe; it could be provided over a subset of the external surfaces of the leadframe.

Figure 10a shows a cross-sectional end view of another IC 1000, and shows a die 1004. In this example the base layer of the leadframe comprises a copper alloy, and the inlay comprises Alloy 42. That is, the materials for the base layer and the inlay of figure 9a have generally been reversed.

Figure 10b shows a close up view of the die 1004 and a bond pad region 1002 of the leadframe. In this example, the leadframe of the IC has been manufactured using an Alloy 42 inlay at the bond pad regions, and also a flash copper plating operation. Therefore, the IC includes an inlay-portion 1014 of Alloy 42 material that is present in the leadframe at the bond pad region 1002, as provided by the inlay. The IC also includes an outer-portion 1015 of copper material over the entire leadframe.

One or more of the examples disclosed herein include a relatively thick copper layer created on a top area of a leadframe for bonding, instead of uniformly covering all of the leadframe surface with a thick copper layer. The leadframe can include a clad metal insert on the functional area and may not require a clad metal sheet on the whole leadframe.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

It will be appreciated that any components said to be coupled may be coupled or connected either directly or indirectly. In the case of indirect coupling, additional components may be located between the two components that are said to be coupled.

## Claims

1. A method of manufacturing a leadframe, comprising:
inserting an inlay into an indentation in a base layer to provide a leadframe-material, wherein the base layer comprises a first material and the inlay comprises a second material;
forming a leadframe from the leadframe-material;
wherein the first material comprises one of copper and Alloy 42, and the second material comprises the other of copper and Alloy 42; **characterised in that**
plating the leadframe with copper-plating, wherein the copper-plating has a thickness of less than 2µm; and
plating the leadframe with copper-plating comprises providing copper plating over a subset of the external surfaces of the leadframe.

2. The method of claim 1, wherein the first material comprises Alloy 42, and the second material comprises copper.

3. The method of claim 2, wherein the second material has a thickness of 4µm to 20µm.

4. The method of claim 1, wherein the first material comprises copper, and the second material comprises Alloy 42.

5. The method of any preceding claim, wherein the copper comprises a copper alloy.

6. The method of any preceding claim, wherein the indentation in the base layer comprises a groove.

7. The method of claim 6, wherein the groove is straight.

8. The method of claim 6 or claim 7, further comprising:
engraving the groove in the second material.

9. The method of any preceding claim, further comprising:
applying pressure to the leadframe-material before forming the leadframe from the leadframe-material.

10. A leadframe comprising:
a base layer having an indentation, wherein the base layer comprises a first material;
an inlay located within the indentation, wherein the inlay comprises a second material;
wherein the first material comprises one of copper and Alloy 42, and the second material comprises the other of copper and Alloy 42, **characterised in that** the leadframe is plated with copper to a thickness of less than 2µm and the copper plating is provided over a subset of the external surfaces of the leadframe.

11. The leadframe of claim 10, wherein the inlay is located at a bond pad region of the leadframe.

12. An integrated circuit comprising the leadframe of any one of claims 10 or 11.

## Patentansprüche

1. Verfahren zum Herstellen eines Leadframes, das Folgendes umfasst:
Einlegen einer Einlage in eine Vertiefung in einer Basisschicht, um ein Leadframe-Material bereitzustellen, wobei die Basisschicht ein erstes Material umfasst und die Einlage ein zweites Material umfasst;
Bilden eines Leadframes aus dem Leadframe-Material;
wobei das erste Material eines von Kupfer und Alloy 42 umfasst und das zweite Material das andere von Kupfer und Alloy 42 umfasst; **gekennzeichnet**
**durch** Plattieren des Leadframes mit einer Kupferplattierung, wobei die Kupferplattierung eine Dicke von weniger als 2 µm aufweist; und
**dadurch**, dass das Plattieren des Leadframes mit einer Kupferplattierung das Bereitstellen der Kupferplattierung über einer Teilmenge der äußeren Oberflächen des Leadframes umfasst.

2. Verfahren nach Anspruch 1, wobei das erste Material Alloy 42 umfasst und das zweite Material Kupfer umfasst.

3. Verfahren nach Anspruch 2, wobei das zweite Material eine Dicke von 4 µm bis 20 µm aufweist.

4. Verfahren nach Anspruch 1, wobei das erste Material Kupfer umfasst und das zweite Material Alloy 42 umfasst.

5. Verfahren nach einem der vorangehenden Ansprüche, wobei das Kupfer eine Kupferlegierung umfasst.

6. Verfahren nach einem der vorangehenden Ansprüche, wobei die Vertiefung in der Basisschicht eine Rille umfasst.

7. Verfahren nach Anspruch 6, wobei die Rille gerade ist.

8. Verfahren nach Anspruch 6 oder Anspruch 7, das ferner Folgendes umfasst:
Eingravieren der Rille in das zweite Material.

9. Verfahren nach einem der vorangehenden Ansprüche, das ferner Folgendes umfasst:
Ausüben von Druck auf das Leadframe-Material vor dem Bilden des Leadframes aus dem Leadframe-Material.

10. Leadframe, der Folgendes umfasst:
eine Basisschicht, die eine Vertiefung aufweist, wobei die Basisschicht ein erstes Material umfasst;
eine sich in der Vertiefung befindende Einlage, wobei die Einlage ein zweites Material umfasst;
wobei das erste Material eines von Kupfer und Alloy 42 umfasst und das zweite Material das andere von Kupfer und Alloy 42 umfasst, **dadurch gekennzeichnet, dass** der Leadframe mit Kupfer bis zu einer Dicke von weniger als 2 µm plattiert ist und die Kupferplattierung über einer Teilmenge der äußeren Oberflächen des Leadframes bereitgestellt ist.

11. Leadframe nach Anspruch 10, wobei sich die Einlage an einem Bond-Pad-Bereich des Leadframes befindet.

12. Integrierte Schaltung, die den Leadframe nach einem der Ansprüche 10 oder 11 umfasst.

## Revendications

1. Procédé de fabrication d'une grille de connexion, comprenant :
l'insertion d'une incrustation dans une empreinte dans une couche de base pour fournir un matériau de grille de connexion, la couche de base comprenant un premier matériau et l'incrustation comprenant un second matériau ;
la formation d'une grille de connexion à partir du matériau de grille de connexion ;
dans lequel le premier matériau comprend l'un de cuivre ou d'alliage 42, et le second matériau comprend l'autre du cuivre et de l'alliage 42 ; **caractérisé par** le plaquage de la grille de connexion par cuivrage, le cuivrage ayant une épaisseur de moins de 2 µm ; et
en ce que le plaquage de la grille de connexion par cuivrage comprend la fourniture d'un cuivrage par-dessus un sous-ensemble des surfaces externes de la grille de connexion.

2. Procédé selon la revendication 1, dans lequel le premier matériau comprend l'alliage 42, et le second matériau comprend le cuivre.

3. Procédé selon la revendication 2, dans lequel le second matériau a une épaisseur de 4 µm à 20 µm.

4. Procédé selon la revendication 1, dans lequel le premier matériau comprend le cuivre, et le second matériau comprend l'alliage 42.

5. Procédé selon l'une quelconque des revendications précédentes, dans lequel le cuivre comprend un alliage de cuivre.

6. Procédé selon l'une quelconque des revendications précédentes, dans lequel l'empreinte dans la couche de base comprend une rainure.

7. Procédé selon la revendication 6, dans lequel la rainure est droite.

8. Procédé selon la revendication 6 ou la revendication 7, comprenant en outre :
la gravure de la rainure dans le second matériau.

9. Procédé selon l'une quelconque des revendications précédentes, comprenant en outre :
l'application de pression sur le matériau de grille de connexion avant la formation de la grille de connexion à partir du matériau de grille de connexion.

10. Grille de connexion comprenant :
une couche de base présentant une empreinte, la couche de base comprenant un premier matériau ;
une incrustation située à l'intérieur de l'empreinte, l'incrustation comprenant un second matériau ;
dans lequel le premier matériau comprend un de cuivre et d'alliage 42, et le second matériau comprend l'autre du cuivre et de l'alliage 42, **caractérisée en ce que** la grille de connexion est cuivrée jusqu'à une épaisseur de moins de 2 µm et le cuivrage est fourni par-dessus un sous-ensemble des surfaces externes de la grille de connexion.

11. Grille de connexion selon la revendication 10, dans laquelle l'incrustation est placée au niveau d'une région de plage de connexion de la grille de connexion.

12. Circuit intégré comprenant la grille de connexion selon l'une quelconque des revendications 10 ou 11.
